# EUROPÄISCHE PATENTSCHRIFT

(11) **EP 2 984 495 B1**
(45) Veröffentlichungstag und Bekanntmachung des Hinweises auf die Patenterteilung: **05.06.2019**
(21) Anmeldenummer: 14727389.0
(22) Anmeldetag: 04.04.2014
(51) Int. Cl.: G06F 11/273, G06F 11/30, G01R 31/319, G01R 31/28, G06F 11/36

(54) **MEHRBENUTZERFÄHIGE TESTUMGEBUNG FÜR EINE MEHRZAHL VON TESTOBJEKTEN**
MULTIUSER-CAPABLE TEST ENVIRONMENT FOR A PLURALITY OF TEST OBJECTS
ENVIRONNEMENT DE TEST POUVANT ÊTRE UTILISÉ PAR PLUSIEURS UTILISATEURS POUR UNE PLURALITÉ D'OBJETS À TESTER

(30) Priorität: 09.04.2013 DE 102013006012
(43) Veröffentlichungstag der Anmeldung: 17.02.2016
(73) Patentinhaber: Airbus Defence and Space GmbH, 85521 Ottobrunn (DE)
(72) Erfinder: WAGER, Philipp, 84036 Landshut (DE); SCHUMACHER, Bernd, 85049 Ingolstadt (DE)
(74) Vertreter: LKGLOBAL Lorenz & Kopf PartG mbB Patentanwälte
(86) Internationale Anmeldenummer: PCT/DE2014/000169
(87) Internationale Veröffentlichungsnummer: WO 2014/166470

(56) Entgegenhaltungen:
- GB-A- 2 005 848
- US-A- 4 760 330
- RAJSUMAN R: "An Overview of the Open Architecture Test System", ELECTRONIC DESIGN, TEST AND APPLICATIONS, 2004. DELTA 2004. SECOND IEE E INTERNATIONAL WORKSHOP ON PERTH, AUSTRALIA 28-30 JAN. 2004, PISCATAWAY, NJ, USA,IEEE, 28. Januar 2004 (2004-01-28), Seiten 341-341, XP010778701, DOI: 10.1109/DELTA.2004.10026 ISBN: 978-0-7695-2081-0

## Beschreibung

### Gebiet der Erfindung

Die Erfindung betrifft eine Testumgebung zum Testen von Testobjekten, welche beispielsweise ein technisches System, ein Subsystem eines technischen Systems oder eine sonstige technische Komponente und insbesondere sicherheitsrelevante technische Komponente wie z. B. eine Komponente eines Flugzeugs oder eines Flugzeugcomputers sein kann.

### Hintergrund der Erfindung

Technische Komponenten können erfordern, nach ihrer Entwicklung und vor ihrer Verwendung auf ihr Verhalten in verschiedenen Situationen getestet zu werden. Ein solcher Test kann aus mehreren Testfällen bestehen, wobei jeder Testfall einen Satz von Eingabedaten und einen Satz von erwarteten Ausgangsdaten aufweist. Vereinfacht ausgedrückt wird das Testobjekt mit den Eingabedaten beaufschlagt und die Reaktion bzw. das Verhalten des Testobjekts auf diese Eingabedaten hin erfasst. Die so erfassten Daten werden anschließend mit den diesem Testfall zugeordneten erwarteten Ausgangsdaten verglichen. Eine Übereinstimmung zwischen den erfassten Daten und den erwarteten Ausgabedaten deutet auf eine richtige Funktion des Testobjekts in dem entsprechenden Testfall hin. Ein Abweichen der erfassten Daten von den vorgegebenen und erwarteten Ausgangsdaten kann auf eine Fehlfunktion des Testobjekts hinweisen.

Unter Umständen kann es erforderlich sein, eine Testumgebung auf ein bestimmtes Testobjekt anzupassen, sei es betreffend die mechanische Kopplung des Testobjekts mit der Testumgebung oder die signaltechnische Kopplung des Testobjekts mit der Testumgebung zur Beaufschlagung des Testobjekts mit den Eingangsdaten eines Testfalls und zum Auslesen der Ausgangsdaten im Anschluss an einen Testfall.

Ein Testfall wird üblicherweise von einer Testfalldurchführungseinheit gestartet und die Durchführung des Testfalls überwacht, wobei eine einzelne Testfalldurchführungseinheit bereitgestellt wird, um Testfälle an dem Testobjekt durchzuführen. Wird ein neuartiges oder variiertes Testobjekt zum Testen in der Testumgebung bereitgestellt, so kann es erforderlich sein, die Testumgebung an das variierte Testobjekt anzupassen.

US 4,760,330 beschreibt ein Testsystem mit geteilten Testinstrumenten. Es ist vorgesehen, dass mehrere Teststationen bereitgestellt sind zum simultanen Testen von Testobjekten. Auch wird eine Vielzahl von Testinstrumenten bereitgestellt, welche wahlweise einem der Testobjekte zugeordnet werden können.

### Zusammenfassung der Erfindung

Es kann als eine Aufgabe der Erfindung betrachtet werden, eine verbesserte wirtschaftliche Nutzung einer Testumgebung und den wahlweisen Zugriff von mehreren Testfalldurchführungseinheiten auf eines oder mehrere Testobjekte zu ermöglichen.

Die Aufgabe der Erfindung wird gelöst durch den Gegenstand mit den Merkmalen gemäß dem unabhängigen Patentanspruch. Weiterbildungen der Erfindung ergeben sich aus den abhängigen Patentansprüchen und der folgenden Beschreibung.

Gemäß einem Aspekt der Erfindung ist eine Testumgebung zum Testen von Testobjekten angegeben. Die Testumgebung weist eine erste Testfalldurchführungseinheit und eine zweite Testfalldurchführungseinheit sowie ein erstes Testobjekt und ein zweites Testobjekt auf. Die Testumgebung ist dabei ausgeführt, dass zumindest eine Testfalldurchführungseinheit der ersten Testfalldurchführungseinheit und der zweiten Testfalldurchführungseinheit mit einem Testobjekt des ersten Testobjekts und des zweiten Testobjekts zum Durchführen eines Testfalls gekoppelt werden kann.

Somit wird ermöglicht, eine Testfalldurchführungseinheit alternativ mit einem ersten Testobjekt oder mit einem zweiten Testobjekt zu koppeln und einen Testfall auf dem entsprechenden Testobjekt zu initiieren. Die Kopplung der Testfalldurchführungseinheiten und den Testobjekten kann dabei insbesondere so erfolgen, dass ein Testobjekt zu einem Zeitpunkt höchstens einem Testfall ausgesetzt ist. Umgekehrt kann der Testfall des ersten Testobjekts und der Testfall des zweiten Testobjekts von einer Testfalldurchführungseinheit initiiert werden.

Die Kopplung zwischen einer Testfalldurchführungseinheit und einem Testobjekt ist reversibel, d. h. dass ein Testobjekt nach der Durchführung eines Testfalls der ersten Testfalldurchführungseinheit von der ersten Testfalldurchführungseinheit abgekoppelt werden kann und zur Durchführung eines weiteren Testfalls mit der zweiten Testfalldurchführungseinheit gekoppelt werden kann. In anderen Worten wird damit eine starre Kopplung zwischen einem Testobjekt und einer Testfalldurchführungseinheit verhindert und das Durchführen verschiedener und mehrerer Testfälle von unterschiedlichen Testfalldurchführungseinheiten nacheinander ermöglicht. Die Testfalldurchführungseinheiten können von dem Testobjekt auch räumlich getrennt sein. Dies bedeutet, dass ein Testfall durch einen Fernzugriff auf das Testobjekt beaufschlagt wird. Die Testfalldurchführungseinheiten können räumlich auch so verteilt sein, dass diese sich in unterschiedlichen Zeitzonen befinden, so dass eine möglichst wirtschaftliche Nutzung des Testobjekts bzw. der Testumgebung sowie der zur Verfügung stehenden Zeit zum Durchführen von Testfällen ermöglicht wird.

Die Testumgebung wie oben und im Folgenden beschrieben ermöglicht damit insbesondere die Mehrfachverwendung einer Testfalldurchführungseinheit und stellt daneben eine mehrbenutzerfähige Testumgebung zur Verfügung, d. h. dass mehrere Benutzer, die räumlich oder geografisch verteilt sein können, auf ein Testobjekt oder auch auf mehrere verschiedene Testobjekte zugreifen können.

Gemäß einer Ausführungsform ist der Zugriff einer Testfalldurchführungseinheit auf ein Testobjekt orts- und zeitunabhängig möglich. Ortsunabhängig bedeutet, dass eine Testfalldurchführungseinheit von einem beliebigen Ort aus und insbesondere über Fernzugriff von einem entfernten Ort aus auf ein Testobjekt zugreifen kann. Zwischen dem Testobjekt und dem entfernten Ort kann insbesondere eine unmittelbare Sichtverbindung, z.B. eines Bedieners der Testfalldurchführungseinheit, nicht bestehen. Zeitunabhängig bedeutet, dass zu einer beliebigen Zeit von einer Testfalldurchführungseinheit auf ein Testobjekt zugegriffen werden kann.

Gemäß einer Ausführungsform sind die Testobjekte räumlich voneinander getrennt.

Dies ermöglicht insbesondere das Zusammenwirken mehrerer räumlich voneinander getrennt angeordneter Testobjekte in einem gemeinsamen Testszenario.

Gemäß einer Ausführungsform ist die Testumgebung ausgeführt, dass die zumindest eine Testfalldurchführungseinheit der ersten Testfalldurchführungseinheit und der zweiten Testfalldurchführungseinheit sowohl mit dem ersten Testobjekt als auch mit dem zweiten Testobjekt zum Durchführen jeweils eines Testfalls gekoppelt werden kann.

Dies bedeutet, dass eine Testfalldurchführungseinheit mit mehr als einem Testobjekt gekoppelt werden kann, um auf jedem Testobjekt einzeln einen Testfall zu initiieren und durchzuführen. Die Steuerung und Überwachung der Testfälle bzw. der Testobjekte kann dabei durch die eine Testfalldurchführungseinheit nebenläufig bzw. quasiparallel erfolgen. Auf der anderen Seite kann jedoch ein Testobjekt zu einem Zeitpunkt mit höchstens einer Testfalldurchführungseinheit gekoppelt sein.

Gemäß einer weiteren Ausführungsform weist die Testumgebung ein drittes Testobjekt auf und ist ausgeführt, dass die andere Testfalldurchführungseinheit der ersten Testfalldurchführungseinheit und der zweiten Testfalldurchführungseinheit mit dem dritten Testobjekt zum Durchführen eines Testfalls gekoppelt werden kann.

Eine Testfalldurchführungseinheit, beispielsweise die erste Testfalldurchführungseinheit, kann damit mit dem ersten Testobjekt und dem zweiten Testobjekt gekoppelt sein, wohingegen die andere Testfalldurchführungseinheit, beispielsweise die zweite Testfalldurchführungseinheit, mit dem dritten Testobjekt gekoppelt sein kann. In diesem Zusammenhang sei insbesondere darauf hingewiesen, dass die Testumgebung wie oben und im Folgenden beschrieben eine jede Kopplung zwischen einer Testfalldurchführungseinheit und den Testobjekten zulässt, solange ein Testobjekt zu einem Zeitpunkt höchstens einen Testfall von einer einzelnen Testfalldurchführungseinheit durchführt.

Gemäß einer weiteren Ausführungsform der Erfindung weist die Testumgebung weiterhin ein Verbindungswerk auf, welches ausgeführt ist, wahlweise die erste Testfalldurchführungseinheit oder die zweite Testfalldurchführungseinheit mit dem ersten Testobjekt und/oder mit dem zweiten Testobjekt zu koppeln.

Bei dem Verbindungswerk kann es sich um ein Schaltwerk oder einen sogenannten Multiplexer handeln, welches eine Eingangsschnittstelle zum Anschließen der Testfalldurchführungseinheiten und eine Ausgangsschnittstelle zum Anschließen der Testobjekte aufweist.

Die Eingangsschnittstelle weist eine Mehrzahl von Anschlusselementen auf, wobei jede Testfalldurchführungseinheit einem Anschlusselement zugeordnet ist bzw. mit diesem Anschlusselement verbunden ist. Sinngemäß das Gleiche gilt für die Verbindung der Ausgangsschnittstelle mit den Testobjekten.

Das Verbindungswerk ermöglicht das Durchführen bzw. Schalten eines Anschlusselementes der Eingangsschnittstelle auf ein Anschlusselement oder mehrere Anschlusselemente der Ausgangsschnittstelle, so dass die entsprechende Testfalldurchführungseinheit mit einem Testobjekt oder mehreren Testobjekten durch das Verbindungswerk gekoppelt wird.

Gemäß einer weiteren Ausführungsform der Erfindung weist die Testumgebung einen Verbindungsbus auf, welcher ausgeführt ist, alle Testfalldurchführungseinheiten mit allen Testobjekten zu verbinden, so dass wahlweise jede Testfalldurchführungseinheit mit jedem Testobjekt gekoppelt werden kann.

Der Verbindungsbus stellt damit zunächst lediglich die Möglichkeit bereit, eine Testfalldurchführungseinheit mit einem Testobjekt tatsächlich zu koppeln, wobei diese Kopplung unabhängig und zusätzlich zu der bereitgestellten Verbindung der Testfalldurchführungseinheiten mit den Testobjekten zu erfolgen hat.

Die Kopplung zwischen einer Testfalldurchführungseinheit und einem Testobjekt kann in einer Ausführungsform über beide Wege, nämlich über das Verbindungswerk und über den Verbindungsbus, erfolgen. Dies kann insbesondere die Ausfallsicherheit der Testumgebung bzw. die Ausfallsicherheit der signaltechnischen Kopplung zwischen einer Testfalldurchführungseinheit und einem Testobjekt erhöhen.

Bei dem Verbindungsbus kann es sich um einen Datenübertragungsbus handeln, über welchen Informationen übertragen werden und entweder an ein Testobjekt oder an eine Testfalldurchführungseinheit adressiert sind. Bei dem Verbindungsbus kann es sich um jegliches Bussystem handeln, welches in der Automatisierungstechnik, insbesondere unter Echtzeitanforderungen und weiter insbesondere unter sogenannten weichen Echtzeitanforderungen, eingesetzt werden kann. Ein Beispiel für einen solchen Bus ist das sogenannte EtherCAT.

Gemäß einer weiteren Ausführungsform der Erfindung weist die Testumgebung weiterhin eine Mehrzahl von Simulationshardwareeinheiten auf, welche von den Testobjekten im Rahmen eines Testfalls angesteuert werden, wobei wahlweise jede der Mehrzahl von Simulationshardwareeinheiten über das Verbindungswerk mit einem Testobjekt gekoppelt werden kann.

Für den Fall, dass ein Steuer- oder Regelwerk gemeinsam bzw. zusammen mit der gesteuerten oder geregelten Komponente getestet wird, muss der Steuer- bzw. Regelkomponente, welche das Testobjekt ist, auch ein Zugriff auf die gesteuerte oder geregelte technische Komponente, welche die Simulationshardwareeinheit ist, gegeben werden. Bei der Simulationshardwareeinheit kann es sich alternativ um ein Modell der gesteuerten oder geregelten technischen Komponente handeln, welches das gleiche Verhalten aufweist wie die zu steuernde oder zu regelnde technische Komponente. Beispielsweise kann es sich bei dem Testobjekt um einen Flugzeugcomputer handeln und bei der Simulationshardwareeinheit um eine von diesem Flugzeugcomputer überwachte Komponente eines Flugzeugs.

Die Testumgebung wie oben und im Folgenden beschrieben kann eine Mehrzahl verschiedener Simulationshardwareeinheiten aufweisen, wobei die Kopplung zwischen jedem Testobjekt und jeder Simulationshardwareeinheit erfolgen kann. Diese Kopplung zwischen den Simulationshardwareeinheiten und den Testobjekten kann insbesondere über das Verbindungswerk oder über den Verbindungsbus erfolgen.

Gemäß einer weiteren Ausführungsform der Erfindung weist die Testumgebung weiterhin eine Mehrzahl von Signalabgriffen auf, von denen jeweils einer jedem Testobjekt zugeordnet ist und ausgeführt ist, die an das Testobjekt übertragenen und von dem Testobjekt ausgegebenen Daten auszulesen.

Ein Signalabgriff kann damit der Analyse der von dem Testobjekt ausgegebenen Daten sowie der Diagnose und Fehlersuche dienen. Unabhängig von dem Vorhandensein oder von der Funktionsweise einer Testfalldurchführungseinheit können die von einem Testobjekt ausgegebenen Daten über den Signalabgriff ausgelesen werden und einer zusätzlichen Auswertung zugeführt werden.

Gemäß einer weiteren Ausführungsform der Erfindung ist zumindest ein Signalabgriff der Mehrzahl von Signalabgriffen ausgeführt, Daten aufnehmen zu können, die als Eingangssignal an das diesem Signalabgriff zugeordnete Testobjekt weitergeleitet werden können.

Dies bedeutet, dass ein Signalabgriff nicht nur dem Auslesen von Daten dienen kann, sondern auch dem Eingeben von Daten, beispielsweise von Testfällen oder von Störungen bzw. Störungssignalen, um das Verhalten des Testobjekts beim Empfang von Störungssignalen oder gestörten Signalen zu überprüfen. Daneben kann damit über den Signalabgriff unabhängig von dem Vorhandensein einer Testfalldurchführungseinheit ein Testfall initiiert und durchgeführt werden.

Gemäß einer weiteren Ausführungsform der Erfindung weist die Testumgebung weiterhin eine Steuereinrichtung auf, welche ausgeführt ist, die Kopplung der Testfalldurchführungseinheiten mit den Testobjekten und die Kopplung der Testobjekte mit den Simulationshardwareeinheiten über das Verbindungswerk zu steuern.

Der Steuereinrichtung kommt damit die Aufgabe zu, die Testumgebung und sämtliche Bestandteile der Testumgebung von zentraler Stelle aus zu überwachen und gemäß einer globalen Testanleitung miteinander zu koppeln.

Die Testumgebung wie oben und im Folgenden beschrieben ermöglicht einen modularen Aufbau und eine wahlweise Verknüpfung von Testfalldurchführungseinheiten, Testobjekten und Simulationshardwareeinheiten, so dass insbesondere einer Mehrzahl von Bedienern oder Testern der Zugriff auf eines oder mehrere Testobjekte ermöglicht wird, wobei gleichzeitig die Verwendung der Testumgebung für eine Vielzahl unterschiedlicher Testobjekte ermöglicht wird, ohne dass dabei die gesamte Testumgebung an ein Testobjekt angepasst werden muss. Dabei kommt dem Verbindungswerk die Aufgabe zu, zwischen den unterschiedlichen Testobjekten und den Testfalldurchführungseinheiten eine Kopplung herzustellen.

Im Folgenden werden mit Verweis auf die Figuren Ausführungsbeispiele der Erfindung beschrieben.

### Kurze Beschreibung der Figuren

Fig. 1 zeigt eine schematische Darstellung einer Testumgebung gemäß einem Ausführungsbeispiel der Erfindung.
Fig. 2 zeigt eine schematische Darstellung einer Testumgebung gemäß einem weiteren Ausführungsbeispiel der Erfindung.
Fig. 3 zeigt eine schematische Darstellung einer Testobjektaufnahmeeinrichtung einer Testumgebung gemäß einem weiteren Ausführungsbeispiel der Erfindung.
Fig. 4 zeigt eine schematische Darstellung einer Testumgebung gemäß einem weiteren Ausführungsbeispiel der Erfindung.

### Detaillierte Beschreibung von Ausführungsbeispielen

Die Darstellungen in den Figuren sind schematisch und nicht maßstabsgetreu. Werden in der folgenden Figurenbeschreibung gleiche Bezugsziffern verwendet, so betreffen diese gleiche oder ähnliche Elemente.

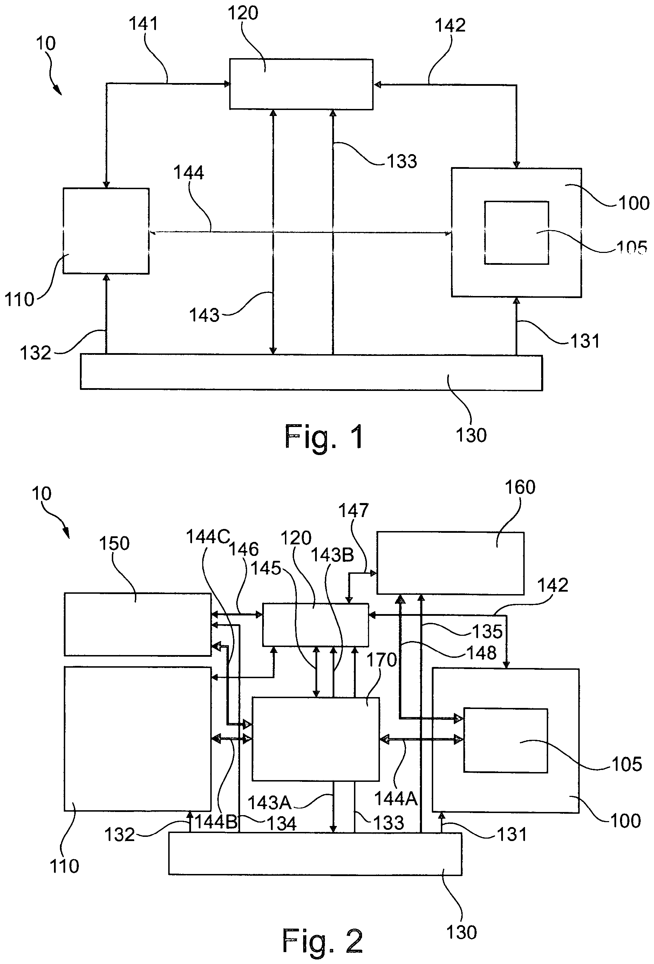

Fig. 1 zeigt eine Testumgebung 10 mit einer Testfalldurchführungseinheit 110 und einem Testobjekt 105, welches in einer Testobjektaufnahmeeinrichtung 100 angeordnet ist. Eine Steuereinrichtung 120 ist vorgesehen, einerseits die Testfalldurchführungseinheit 110 und andererseits die Testobjektaufnahmeeinrichtung 100 und das Testobjekt 105 zu steuern. Ebenso steuert die Steuereinrichtung 120 eine Energieversorgungseinheit 130, welche sowohl die Testfalldurchführungseinheit 110, die Testobjektaufnahmeeinrichtung 100 und das Testobjekt 105 sowie die Steuereinrichtung 120 mit Energie zur Durchführung eines Tests versorgt.

Die unidirektionalen Pfeile 131, 132, 133 stellen schematisch die Energieversorgung der Testobjektaufnahmeeinrichtung 100, der Testfalldurchführungseinheit 110 bzw. der Steuereinrichtung 120 dar. Die Richtung der Pfeile kennzeichnet dabei die Richtung der Bereitstellung von Energie. Die bidirektionalen Pfeile symbolisieren Datenverbindungen zwischen den entsprechenden Komponenten. Die Steuereinrichtung 120 hat eine Datenverbindung 141 zu der Testfalldurchführungseinheit 110, eine Datenverbindung 142 zu der Testobjektaufnahmeeinrichtung 100 bzw. zu dem darin angeordneten Testobjekt 105 und eine Datenverbindung 143 zu der Energieversorgungseinheit 130. Über diese Datenverbindungen erfolgt die Steuerung der gesamten Testumgebung bzw. des Testszenarios.

Daneben existiert noch eine Datenverbindung 144 zwischen der Testfalldurchführungseinheit 110 und der Testobjektaufnahmeeinrichtung 100, wobei über diese Datenverbindung 144 der eigentliche Testfall durch die Testfalldurchführungseinheit 110 initiiert und durchgeführt wird sowie die Ausgabedaten des Testobjekts 105 empfangen werden.

Die Testfalldurchführungseinheit 110 ist ausgeführt, Daten über eine vorgegebene mechanische und elektrische Verbindung 144 mit der Testobjektaufnahmeeinrichtung 100 auszutauschen. Diese Daten werden von der Testobjektaufnahmeeinrichtung 100 angepasst an die Schnittstelle des Testobjekts 105, so dass bei einem neuartigen Testobjekt lediglich die Testobjektaufnahmeeinrichtung 100 an die mechanische und elektrische Schnittstelle des Testobjekts 105 angepasst werden muss, wobei die Verbindung sowohl hinsichtlich der mechanischen als auch der elektrischen Schnittstelle zu der Testfalldurchführungseinheit 110 beibehalten werden kann. In anderen Worten erfolgt hierbei eine sogenannte Kapselung der mechanischen, elektrischen und signaltechnischen Schnittstellen des Testobjekts 105 durch die Testobjektaufnahmeeinrichtung 100, so dass bei einem neuen Testobjekt lediglich die Testobjektaufnahmeeinrichtung 100 an das Testobjekt angepasst wird, ohne dabei die mechanischen, elektrischen und signalübertragungstechnischen Schnittstellen der Testobjektaufnahmeeinrichtung zu der Testfalldurchführungseinheit anzupassen. Das Entwerfen und Qualifizieren einer Testumgebung im Ganzen kann damit weitestgehend verhindert werden, wenn ein neuartiges Testobjekt zu testen ist. Unter dem sogenannten Qualifizieren der Testumgebung versteht man dabei das Überprüfen der Testumgebung an sich auf richtige Funktion.

Fig. 2 zeigt eine Testumgebung 10, die neben den bereits in Fig. 1 gezeigten Komponenten zusätzlich eine Simulationshardwareeinheit 150 und ein Ein-/Ausgabeelement 160 sowie ein Verbindungswerk 170 aufweist.

Das Verbindungswerk 170 ist ausgeführt, die Testfalldurchführungseinheit 110, die Simulationshardwareeinheit 150 und das in der Testobjektaufnahmeeinrichtung 100 befindliche Testobjekt 105 miteinander zu koppeln. Die Kopplung zwischen diesen Komponenten wird über die Steuereinrichtung 120 und die Datenverbindung 145 zwischen der Steuereinrichtung 120 und dem Verbindungswerk 170 gesteuert.

Die Ein-/Ausgabeelemente 160 dienen der lokalen Steuerung des Testobjekts 105 über die Datenverbindung 148. Hierüber kann das Testobjekt beispielsweise eingeschaltet oder in einem Notfall ausgeschaltet bzw. deaktiviert werden. Ebenso könnte über die Elemente 160 ein Betriebsmodus des Testobjekts vorgegeben werden.

Im Gegensatz zu dieser Steuerung des Testobjekts über die in räumlicher Nähe oder sogar Sichtweite zu dem Testobjekt 105 angebrachten Ein-/Ausgabeelemente 160 kann das Initiieren und Durchführen eines Testfalls durch die Testfalldurchführungseinheit 110 über die Datenverbindung 144A, 144B auch über einen Fernzugriff erfolgen. Dies bedeutet, dass die Testfalldurchführungseinheit 110 räumlich getrennt von dem Testobjekt angeordnet ist und die Verbindung beispielsweise über ein öffentliches oder privates Datennetz zwischen dem Testobjekt und der Testfalldurchführungseinheit hergestellt wird.

Ebenso wie die Testfalldurchführungseinheit 110 räumlich getrennt von dem Testobjekt 105 angeordnet sein kann, kann auch die Simulationshardwareeinheit 150 räumlich getrennt von dem Testobjekt 105 angeordnet sein. Dies ermöglicht beispielsweise die gemeinsame Nutzung einer nur einmal vorhandenen Simulationshardwareeinheit 150 durch mehrere verschiedene Testobjekte 105, von denen alle an unterschiedlichen Orten entfernt und unabhängig von der Simulationshardwareeinheit 150 platziert sein können.

Auch hier wird deutlich, dass die Testumgebung 10 wie oben und im Folgenden beschrieben eine Mehrfachverwendung von Komponenten, beispielsweise der Simulationshardwareeinheit 150 ermöglicht, wie auch ein Mehrfachzugriff mehrerer Benutzer, die räumlich getrennt voneinander und von dem Testobjekt sind, auf ein Testobjekt nacheinander ermöglicht wird.

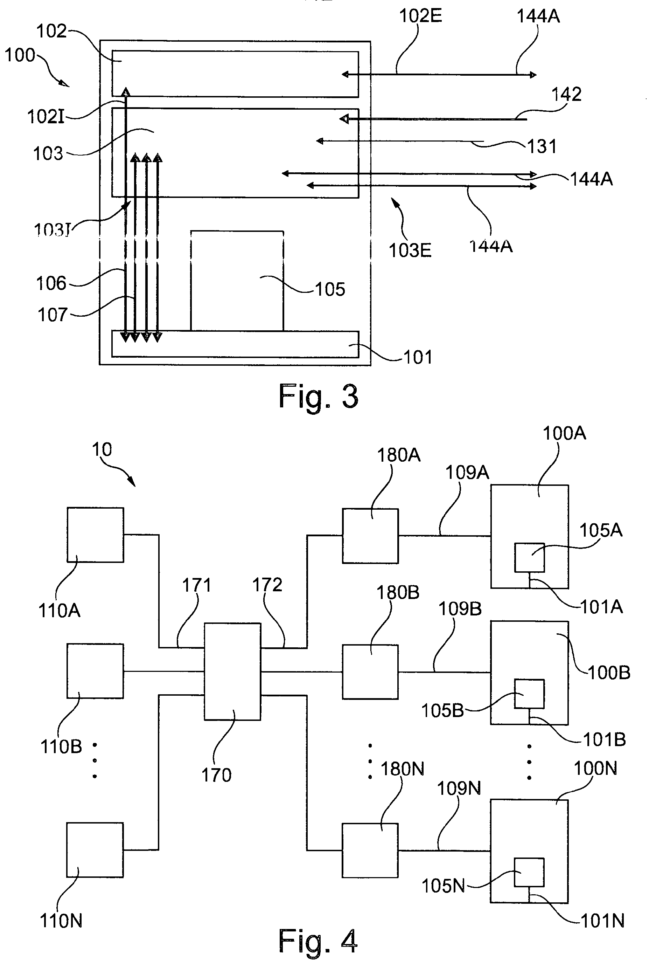

Fig. 3 zeigt eine Testobjektaufnahmeeinrichtung 100 mit einem Testobjekt 105. Das Testobjekt 105 ist mit einem Aufnahmeelement 101 mechanisch und elektrisch gekoppelt. Das Aufnahmeelement 101 bildet damit die Schnittstelle der Testobjektaufnahmeeinrichtung zu dem Testobjekt 105 und ist jeweils an die mechanischen, elektrischen und signalübertragungstechnischen Auflagen zur Verbindung mit dem Testobjekt 105 angepasst.

Die Testobjektaufnahmeeinrichtung 100 weist daneben noch eine Testsignalschnittstelleneinheit 102 und eine Signalschnittstelleneinheit 103 auf. Die Signalschnittstelleneinheit 103 ist ausgeführt, über eine interne Schnittstelle 103I Signale von dem Testobjekt 105 über das Aufnahmeelement 101 entgegen zu nehmen, diese Signale aufzuarbeiten bzw. umzuwandeln und sie über eine externe Schnittstelle 103E über die Datenverbindung 144A an das Verbindungswerk 170 auszugeben. Die Signale des Testobjekts werden von dem Aufnahmeelement 101 über eine Datenverbindung 107 an die Signalschnittstelleneinheit 103 übertragen.

Optional kann die Testobjektaufnahmeeinrichtung 100 eine Testsignalschnittstelleneinheit 102 aufweisen, welche über eine interne Schnittstelle 102I über die Datenverbindung 106 Signale von dem Aufnahmeelement 101 aufnimmt, diese Signale auswertet und ggf. umwandelt und über die externe Schnittstelle 102E und die Datenverbindung 144A ausgibt.

Die Testsignalschnittstelleneinheit 102 ist optional und ermöglicht den Anschluss einer Diagnoseeinheit an die Testobjektaufnahmeeinrichtung, wobei die Diagnoseeinheit Testsignale des Testobjekts auswertet und analysiert.

Die Signalschnittstelleneinheit 103 ist des Weiteren über die Leitung 131 mit der Energieversorgungseinheit 130 verbunden und über die Datenverbindung 142 mit der Steuereinrichtung 120.

In einem Ausführungsbeispiel kann die Testobjektaufnahmeeinrichtung 100 eine abgeschlossene Einheit zum Betrieb des darin eingebetteten Testobjektes 105 sein. Das Aufnahmeelement bzw. die Schnittstelle zum Anschluss des Testobjektes dient der mechanischen, elektrischen und signalübertragungstechnischen Adaption bzw. Kopplung des Testobjekts. Daneben kann das Aufnahmeelement 101 weitere Funktionen beinhalten, wie beispielsweise eine Kühlfunktion, um bei dem Betrieb des Testobjekts entstehende Wärme abzutransportieren. Das Testobjekt wird an dem Aufnahmeelement montiert bzw. befestigt und die Schnittstellen des Testobjekts werden von dem Aufnahmeelement über die Datenverbindungen 106, 107 an die Testsignalschnittstelleneinheit 102 bzw. an die Signalschnittstelleneinheit 103 übertragen. Das Testobjekt 105 kann neben Betriebsschnittstellenanschlüssen auch Diagnose- bzw. Programmierschnittstellenanschlüsse aufweisen. Die Betriebsschnittstellen werden dabei diskret mit der Signalschnittstelleneinheit und die Diagnose- bzw. Programmierschnittstellen werden diskret mit der Testsignalschnittstelleneinheit 102 verbunden. Die Testsignalschnittstelleneinheit ist optional und dient beispielsweise der Fehlersuche oder kann für das Einspielen von Steuerprogrammen in das Testobjekt verwendet werden. Die Signalschnittstelleneinheit 103 führt sämtliche Betriebsschnittstellenanschlüsse des Testobjekts über die externe Schnittstelle 103E aus der Testobjektaufnahmeeinrichtung 100 nach außen. Dieses Herausführen der Schnittstellen des Testobjektes aus der Testobjektaufnahmeeinrichtung kann sowohl diskret verkabelt beispielsweise über Standardstecker als auch logisch über ein Bussystem erfolgen. Diskret verkabelt bedeutet dabei, dass einer Signalleitung auch eine physikalische Leitung zugeordnet ist, und im Gegensatz dazu wird bei einer logischen Verbindung eine Mehrzahl von Verbindungen über eine gemeinsame physikalische Leitung geführt. Eine logische Verbindung kann in einem Ausführungsbeispiel mit einer Signalumwandlung einhergehen, beispielsweise mit einer Änderung der Signalkodierung oder aber mit einer Analog-Digital-Wandlung.

Fig. 4 zeigt eine schematische Darstellung einer Testumgebung 10 mit einer Mehrzahl von Testfalldurchführungseinheiten 110A, 110B, 110N, einer Mehrzahl von Testobjektaufnahmeeinrichtungen 100A, 100B, 100N mit jeweils einem Testobjekt 105A, 105B, 105N, wobei jedes Testobjekt über jeweils ein Aufnahmeelement 101A, 101B, 101N mit der jeweiligen Testobjektaufnahmeeinrichtung verbunden ist und wobei jede Testobjektaufnahmeeinrichtung über eine externe Anschlussschnittstelle 109A, 109B, 109N über jeweils einen Signalabgriff 180A, 180B, 180N mit dem Verbindungswerk 170 verbunden ist.

Die Testfalldurchführungseinheiten 110 sind mit dem Verbindungswerk über jeweils eine Eingangsschnittstelle 171 und die Testobjektaufnahmeeinrichtungen 100 über jeweils eine Ausgangsschnittstelle 172 verbunden. Wie bereits weiter oben beschrieben, ist das Verbindungswerk ausgeführt, eine jede Eingangsschnittstelle mit einer oder mehreren Ausgangsschnittstellen zu verbinden, wobei eine Ausgangsschnittstelle zu einem Zeitpunkt nur mit einer einzelnen Eingangsschnittstelle verbunden sein kann.

Die Testsignalschnittstelleneinheit 102 der Testobjektaufnahmeeinrichtung 100 kann mit ihrer externen Schnittstelle 102E mit dem dieser Testobjektaufnahmeeinrichtung zugeordneten Signalabgriff gekoppelt sein, so dass der Abgriff von Testsignalen zu Diagnosezwecken über den Signalabgriff 180A, 180B, 180N erfolgen kann.

Aus Übersichtlichkeitsgründen wurde in Fig. 4 darauf verzichtet, eine Simulationshardwareeinheit abzubilden. Es sei daher insbesondere darauf hingewiesen, dass mit dem Verbindungswerk 170 eine Mehrzahl von Testfalldurchführungseinheiten 110, eine Mehrzahl von Testobjektaufnahmeeinrichtungen 100 und eine Mehrzahl von Simulationshardwareeinheiten 150, wie in Fig. 2 dargestellt, verbunden werden können. Dabei kann eine Testfalldurchführungseinheit mit einer oder mehreren Testobjektaufnahmeeinrichtungen zur Durchführung eines Testfalls über das Verbindungswerk gekoppelt sein. Ergänzend dazu kann eine Testobjektaufnahmeeinrichtung bzw. das darin enthaltene Testobjekt über das Verbindungswerk mit einer Simulationshardwareeinheit oder mehreren Simulationshardwareeinheiten gekoppelt sein.

In einem Ausführungsbeispiel ist über das Verbindungswerk 170 auch eine direkte Kopplung der Testobjekte miteinander möglich. Damit kann neben einem einzelnen Testobjekt auch ein Verbund miteinander interagierender Testobjekte getestet werden. Interaktion zwischen Testobjekten bezeichnet dabei beispielsweise eine Verbindung, in der zwei oder mehrere Testobjekte Daten miteinander austauschen, ein Testobjekt Daten von einem anderen Testobjekt anfordert oder ein Testobjekt Aktionen in einem anderen Testobjekt hervorruft bzw. das Ergebnis einer Aktion an ein anderes Testobjekt übermittelt.

Das Verbindungswerk ermöglicht auch die Kopplung räumlich voneinander getrennt angeordneter Testobjekte zu einem gemeinsamen Testszenario.

Damit ermöglicht die Testumgebung wie oben und im Folgenden beschrieben einen gleichzeitigen Mehrfachzugriff auf räumlich verteilte oder nicht verteilte Testobjekte ausgehend von einer Testfalldurchführungseinheit bzw. durch einen Benutzer, einen zeitlich aufeinanderfolgenden Zugriff mehrerer Benutzer bzw. mehrerer Testfalldurchführungseinheiten auf dasselbe Testobjekt, einen gleichzeitigen Zugriff eines Testobjekts auf mehrere Simulationshardwareeinheiten, die räumlich verteilt oder nicht verteilt sein können, und abschließend einen zeitlich aufeinanderfolgenden Zugriff mehrerer verschiedener Testobjekte auf dieselbe Simulationshardwareeinheit. Damit wird ein ressourcenschonender Einsatz der Komponenten der Testumgebung ermöglicht und es muss insbesondere nicht für jedes Testobjekt eine neue, hierauf zugeschnittene Testumgebung entworfen und qualifiziert werden.

## Patentansprüche

1. Testumgebung (10) zum Testen von Testobjekten (105), die Testumgebung (10) aufweisend:
eine erste Testfalldurchführungseinheit (110A) und eine zweite Testfalldurchführungseinheit (110B);
ein erstes Testobjekt (105A) und ein zweites Testobjekt (105B);
ein Verbindungswerk (170), welches ausgeführt ist, wahlweise die erste Testfalldurchführungseinheit (110A) oder die zweite Testfalldurchführungseinheit (110B) mit dem ersten Testobjekt (105A) und/oder mit dem zweiten Testobjekt (105B) zu koppeln;
wobei die Testumgebung ausgeführt ist, dass zumindest die erste Testfalldurchführungseinheit mit dem ersten Testobjekt oder dem zweiten Testobjekt zum Durchführen eines Testfalls gekoppelt werden kann;
**dadurch gekennzeichnet, dass** die Testumgebung weiterhin aufweist:
eine Mehrzahl von Simulationshardwareeinheiten (150), welche von den Testobjekten im Rahmen eines Testfalls angesteuert werden;
wobei wahlweise jede der Mehrzahl von Simulationshardwareeinheiten (150) über das Verbindungswerk mit einem Testobjekt gekoppelt werden kann.

2. Testumgebung (10) nach Anspruch 1,
wobei die Testumgebung ausgeführt ist, dass die erste Testfalldurchführungseinheit sowohl mit dem ersten Testobjekt als auch mit dem zweiten Testobjekt zum Durchführen jeweils eines Testfalls gekoppelt werden kann.

3. Testumgebung (10) nach einem der Ansprüche 1 oder 2, weiterhin aufweisend:
ein drittes Testobjekt (105N);
wobei die Testumgebung ausgeführt ist, dass die zweite Testfalldurchführungseinheit mit dem dritten Testobjekt zum Durchführen eines Testfalls gekoppelt werden kann.

4. Testumgebung (10) nach einem der vorhergehenden Ansprüche,
wobei das Verbindungswerk (170) eine Mehrzahl von Eingangsschnittstellen (171) zum Anschließen von jeweils einer Testfalldurchführungseinheit und eine Mehrzahl von Ausgangsschnittstellen (172) zum Anschließen von jeweils einem Testobjekt aufweist;
wobei das Verbindungswerk ausgeführt ist, eine Eingangsschnittstelle mit mindestens zwei Ausgangsschnittstellen zu koppeln, so dass ein Testfalldurchführungseinheit mit den den beiden Ausgangsschnittstellen zugeordneten mindestens zwei Testobjekten gekoppelt ist.

5. Testumgebung (10) nach einem der vorhergehenden Ansprüche, weiterhin aufweisend:
einen Verbindungsbus (144), welcher ausgeführt ist, alle Testfalldurchführungseinheiten mit allen Testobjekten zu verbinden, so dass wahlweise jede Testfalldurchführungseinheit mit jedem Testobjekt gekoppelt werden kann.

6. Testumgebung (10) nach einem der vorhergehenden Ansprüche, weiterhin aufweisend:
eine Mehrzahl von Signalabgriffen (180), von denen jeweils einer jedem Testobjekt zugeordnet ist und ausgeführt ist, die an das Testobjekt übertragenen und von dem Testobjekt ausgegebenen Daten auszulesen.

7. Testumgebung (10) nach Anspruch 6,
wobei zumindest ein Signalabgriff ausgeführt ist, Daten aufnehmen zu können, die als Eingangssignal an das diesem Signalabgriff zugeordnete Testobjekt weitergeleitet werden können.

8. Testumgebung (10) nach einem der vorhergehenden Ansprüche, weiterhin aufweisend:
eine Steuereinrichtung (120), welche ausgeführt ist, die Kopplung der Testfalldurchführungseinheiten (110) mit den Testobjekten (105) und die Kopplung der Testobjekte (105) mit den Simulationshardwareeinheiten (150) über das Verbindungswerk (170) zu steuern.

## Claims

1. Test environment (10) for testing test objects (105), the test environment (10) having:
a first test case implementation unit (110A) and a second test case implementation unit (110B);
a first test object (105A) and a second test object (105B);
a connection mechanism (170) which is designed to selectively couple the first test case implementation unit (110A) or the second test case implementation unit (110B) to the first test object (105A) and/or to the second test object (105B);
wherein the test environment is designed such that at least the first test case implementation unit can be coupled to the first test object or to the second test object for implementing a test case;
**characterized in that** the test environment also has:
a plurality of simulation hardware units (150) which are controlled by the test objects during a test case;
wherein each of the plurality of simulation hardware units (150) can be selectively coupled to a test object via the connection mechanism.

2. Test environment (10) according to Claim 1,
wherein the test environment is designed such that the first test case implementation unit can be coupled both to the first test object and to the second test object for implementing a test case in each case.

3. Test environment (10) according to either of Claims 1 and 2, also having:
a third test object (105N);
wherein the test environment is designed such that the second test case implementation unit can be coupled to the third test object for implementing a test case.

4. Test environment (10) according to one of the preceding claims,
wherein the connection mechanism (170) has a plurality of input interfaces (171) for connecting a test case implementation unit in each case and a plurality of output interfaces (172) for connecting a test object in each case;
wherein the connection mechanism is designed to couple an input interface to at least two output interfaces, with the result that a test case implementation unit is coupled to the at least two test objects assigned to the two output interfaces.

5. Test environment (10) according to one of the preceding claims, also having:
a connection bus (144) which is designed to connect all test case implementation units to all test objects, with the result that each test case implementation unit can be selectively coupled to each test object.

6. Test environment (10) according to one of the preceding claims, also having:
a plurality of signal taps (180), one of which is assigned to each test object in each case and is designed to read the data transmitted to the test object and output by the test object.

7. Test environment (10) according to Claim 6,
wherein at least one signal tap is designed to be able to receive data which can be forwarded, as an input signal, to the test object assigned to this signal tap.

8. Test environment (10) according to one of the preceding claims, also having:
a control device (120) which is designed to control the coupling of the test case implementation units (110) to the test objects (105) and the coupling of the test objects (105) to the simulation hardware units (150) via the connection mechanism (170).

## Revendications

1. Environnement d'essai (10) destiné aux essais d'objets en essai (105), l'environnement d'essai (10) comprenant :
une première unité de réalisation d'essai élémentaire (110A) et une deuxième unité de réalisation d'essai élémentaire (110B) ;
un premier objet en essai (105A) et un deuxième objet en essai (105B) ;
un mécanisme de liaison (170) qui est réalisé pour accoupler, au choix, la première unité de réalisation d'essai élémentaire (110A) ou la deuxième unité de réalisation d'essai élémentaire (110B) au premier objet en essai (105A) et/ou au deuxième objet en essai (105B) ;
l'environnement d'essai étant réalisé de telle sorte qu'au moins la première unité de réalisation d'essai élémentaire peut être accouplée au premier objet en essai ou au deuxième objet en essai en vue de réaliser un essai élémentaire ;
**caractérisé en ce que** l'environnement d'essai comprend en outre :
une pluralité d'unités matérielles de simulation (150) qui sont commandées par les objets en essai dans le cadre d'un essai élémentaire ;
chacune de la pluralité des unités matérielles de simulation (150) pouvant, au choix, être accouplée à un objet en essai par le biais du mécanisme de liaison.

2. Environnement d'essai (10) selon la revendication 1, l'environnement d'essai étant réalisé de sorte que la première unité de réalisation d'essai élémentaire peut être accouplée à la fois au premier objet en essai et au deuxième objet en essai en vue de réaliser respectivement un essai élémentaire.

3. Environnement d'essai (10) selon l'une des revendications 1 ou 2, comprenant en outre :
un troisième objet en essai (105N) ;
l'environnement d'essai étant réalisé de sorte que la deuxième unité de réalisation d'essai élémentaire peut être accouplée au troisième objet en essai en vue de réaliser un essai élémentaire.

4. Environnement d'essai (10) selon l'une des revendications précédentes,
le mécanisme de liaison (170) possédant une pluralité d'interfaces d'entrée (171) destinées au raccordement respectif d'une unité de réalisation d'essai élémentaire et une pluralité d'interfaces de sortie (172) destinées au raccordement respectif d'un objet en essai ;
le mécanisme de liaison étant réalisé pour accoupler une interface d'entrée avec au moins deux interfaces de sortie de sorte qu'une unité de réalisation d'essai élémentaire est accouplée aux au moins deux objets en essai associés aux deux interfaces de sortie.

5. Environnement d'essai (10) selon l'une des revendications précédentes, comprenant en outre :
un bus de liaison (144) qui est réalisé pour relier toutes les unités de réalisation d'essai élémentaire à tous les objets en essai, de sorte que chaque unité de réalisation d'essai élémentaire peut, au choix, être accouplée à chaque objet en essai.

6. Environnement d'essai (10) selon l'une des revendications précédentes, comprenant en outre :
une pluralité de prises de signal (180) parmi lesquelles une est respectivement associée à chaque objet en essai et réalisée pour lire les données transmises à l'objet en essai et délivrées par l'objet en essai.

7. Environnement d'essai (10) selon la revendication 6,
au moins une prise de signal étant réalisée pour pouvoir accueillir des données qui peuvent être retransmises sous forme de signal d'entrée à l'objet en essai associé à cette prise de signal.

8. Environnement d'essai (10) selon l'une des revendications précédentes, comprenant en outre :
un dispositif de commande (120) qui est réalisé pour commander l'accouplement des unités de réalisation d'essai élémentaire (110) avec les objets en essai (105) et l'accouplement des objets en essai (105) avec les unités matérielles de simulation (150) par le biais du mécanisme de liaison (170).
